# EUROPEAN PATENT SPECIFICATION

(11) **EP 2 722 896 B1**
(45) Date of publication and mention of the grant of the patent: **02.11.2016**
(21) Application number: 12800383.7
(22) Date of filing: 18.06.2012
(51) Int. Cl.: H01L 31/042, C08J 5/18, C08G 77/04

(54) **SHEET FOR PHOTOVOLTAIC CELL**
FOLIE FÜR PHOTOVOLTAIKZELLEN
FEUILLE POUR UNE CELLULE PHOTOVOLTAÏQUE

(30) Priority: 17.06.2011 KR 20110059099
(43) Date of publication of application: 23.04.2014
(73) Proprietor: LG Chem, Ltd., Seoul 150-721 (KR)
(72) Inventor: KO, Min Jin, Daejeon 305-707 (KR)
(74) Representative: Goddar, Heinz J.
(86) International application number: PCT/KR2012/004821
(87) International publication number: WO 2012/173461

(56) References cited:
- EP-A1- 2 270 070
- WO-A1-2009/085894
- WO-A1-2010/004932
- WO-A1-2010/021326
- WO-A1-2010/104146
- KR-A- 20060 016 107
- KR-A- 20090 131 274

## Description

### FIELD

The present application relates to a sheet for a photovoltaic cell.

### BACKGROUND

A photovoltaic cell is a semiconductor device capable of converting light into electricity. When the photovoltaic cell is exposed to light, it generates a voltage, thereby inducing an electric flow. The volume of the electric flow is proportional to the collision intensity of the light with respect to a joining part of the photovoltaic cell.

As the photovoltaic cell, a wafer-based photovoltaic cell or a thin film-type photovoltaic cell is used. In a silicon wafer-based photovoltaic cell, a photoelectric transducer is manufactured by a monocrystalline or polycrystalline silicon ingot. And, in a thin film-type photovoltaic cell, a photoelectric transducer is formed on a substrate or a ferroelectric substance by sputtering or deposition.

Since the wafer-based photovoltaic cell and the thin film-type photovoltaic cell have brittleness, a load-bearing support member is required. The load-bearing support member may be a light-transmitted top layer disposed on a top surface of the photovoltaic cell or a bottom layer disposed on a bottom surface of the photovoltaic cell EP2 407 521A1 discloses a solar cell module comprising a laminate made of a substrate and a coating composition. The coating composition comprises metal oxide particles and polymer particles.

It is common that the bottom layer disposed on a bottom surface of the photovoltaic cell is a rigid back skin. Various materials are disclosed as the bottom layer, for example, a glass such as ferroelectric substance, a metal foil such as an aluminum foil, or a polyester polymer sheet or the like upon which a fluorine-based resin or a metal foil is stacked may be used.

### TECHNICAL OBJECT

The present application provides a sheet for a photovoltaic cell.

### SOLUTION

An illustrative sheet for photovoltaic cell use can have a resin layer including a silicon resin and a light resistance providing agent. The silicon resin may comprise an aryl group, for example, an aryl group binding to a silicon atom. The sheet may be used as a support member for a photovoltaic cell, for example, a back sheet.

Herein, the term "M unit" may refer to a monofunctional siloxane unit that is usually represented by the Formula [R₃SiO_{½}]; the term "D unit" may refer to a bifunctional siloxane unit that is usually represented by [R₂SiO_{2/2}]; the term "T unit" may refer to a trifunctional siloxane unit that is usually represented by [RSiO_{3/2}]; and the term "Q unit" may refer to a tetrafunctional siloxane unit usually represented by [SiO_{4/2}]. Herein, "R" is a substituent directly binding to a silicon atom, which may be, for example, hydrogen, a hydroxyl group, an epoxy group, an acryloyl group, a methacryloyl group, an isocyanate groupe, an alkoxy group, or a monovalent hydrocarbon group.

In one embodiment, the sheet for a photovoltaic cell may further include a base layer. When the base layer is comprised, the resin layer may be formed on one or both surfaces of the base layer. The resin layer may be a layer laminated on the base layer formed in a sheet or film shape or a coated layer formed on the base layer. The term "coating layer" refers to a coated layer formed by coating a liquid-type coating solution including the silicon resin or a precursor thereof and a light resistance providing agent.

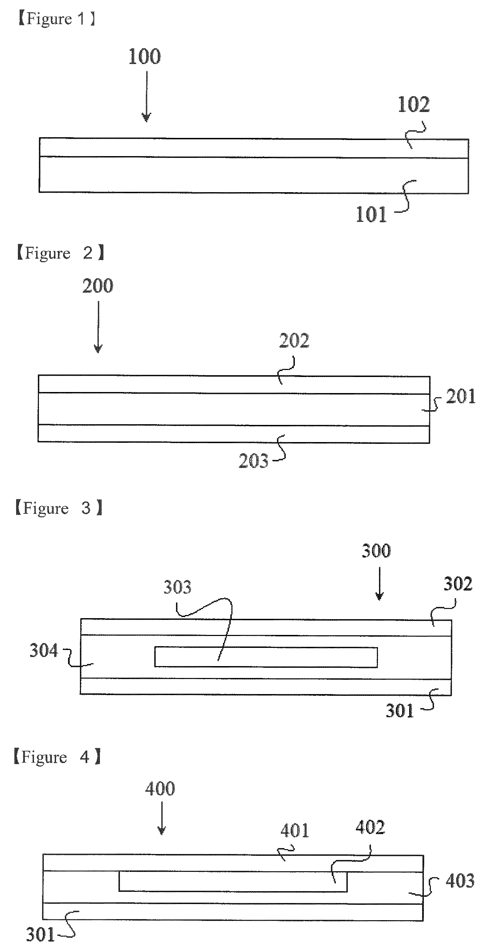

FIGS. 1 and 2 are diagrams of illustrative sheets for a photovoltaic cell (100 and 200). As shown in FIG. 1, the sheet for a photovoltaic cell (100) may include a base layer (101), and a resin layer (102) formed on one surface of the base layer (101). In addition, the sheet for a photovoltaic cell (200), as shown in FIG. 2, may include resin layers (202 and 203) formed on both surfaces of the base layer (201). As shown in FIG. 2, when the resin layers (202 and 203) are formed on both surfaces of the base layer (201), all of the resin layers formed on both surfaces may be resin layers including the silicon resin and the light resistance providing agent, or any one of the resin layers formed on both surfaces is a layer including the silicon resin and the light resistance providing agent, and the resin layer formed on the opposite surface thereof may be a resin layer different therefrom. Here, the particular component of the different resin layer is not particularly limited. In one embodiment, the resin layer formed on the opposite surface may also include a silicon resin. The silicon resin may comprise, for example, an aryl group as described above, and may be a resin having a molar ratio (Ar/Si) of all aryl (Ar) groups comprised in the resin with respect to all silicon (Si) atoms of more than 0.3. In the resin layer, another component such as a light resistance providing agent or the like may be included as needed, but it is possible for the resin layer not to include another component..

As the base layer, for example, a common base layer used as a back sheet for a photovoltaic module may be used. For example, a metal foil; a fluorine resin sheet such as poly(vinyl fluoride) (PVF) or ethylene tetrafluoroethylene (ETFE); or a polyester sheet such as a polyethyleneterephthalate (PET) sheet may be used. As the base layer, at least two selected from the listed sheets, or a stacked sheet on which the listed sheet and another sheet are stacked may be used. For example, as the base layer, a polyester sheet may be used, but the present application is not limited thereto.

A silicon oxide (SiOx) layer or a primer layer may be formed on one or both surfaces of the base layer to improve adhesive strength or barrier property with respect to a resin layer or the like. The silicon oxide (SiOx) layer or primer layer may be formed above the resin layer, between the resin layer and the base layer, or on a surface of the base layer not having a resin layer.

The silicon resin of the resin layer may allow the resin layer to have high adhesiveness with respect to various materials such as an encapsulant in contact with a sheet for a photovoltaic cell in a module. The silicon resin may also improve moisture resistance, weather resistance, and light resistance of the resin layer, and light collecting efficiency of the module.

The silicon resin includes an aryl group, particularly, an aryl group binding to a silicon atom. The term "aryl group" may refer to, unless specifically defined otherwise, a monovalent residue derived from a compound having a benzene ring or including a structure in which at least two benzene rings are connected or condensed, or a derivative thereof. That is, in the range of the "acryl group", an aralkyl group, arylalkyl group, and a functional group conventionally referred to as an aryl group may be included. The aryl group may be, for example, an aryl group having 6 to 25 or 6 to 21 carbon atoms. The aryl group may be a phenyl group, a dichlorophenyl group, a chlorophenyl group, a phenylethyl group, a phenylpropyl group, a benzyl group, a tolyl group, a xylyl group, or a naphthyl group. In one embodiment, the aryl group may be a phenyl group.

The silicon resin may have a molar ratio (Ar/Si) of all aryl (Ar) groups with respect to all silicon (Si) atoms comprised in the resin is more than 0.3, 0.5 or more, or 0.7 or more. When the molar ratio (Ar/Si) is more than 0.3, the moisture resistance, weather resistance, and hardness of the resin layer may be enhanced, and light collecting efficiency in the photovoltaic module may be increased. The upper limit of the molar ratio (Ar/Si) of the aryl group is not limited. But, may be, for example, 1.5 or less or 1.2 or less.

The aryl group of the silicon resin may be included, for example, in a D or T unit. 2. The silicon resin includes a siloxane unit of Formula 1 and a siloxane unit of Formula 2

[Formula 1] [R¹R²SiO_{2/2}]

[Formula 2] [R³SiO_{3/2}]

In Formulas 1 and 2, R¹ and R² are each independently hydrogen, a hydroxyl group, an epoxy group, an acryloyl group, a methacryloyl group, an isocyanate group, an alkoxy group, or a monovalent hydrocarbon group, and at least one of the R¹ and R² is an aryl group, and R³ is an aryl group.

The term "alkoxy group" may refer to, unless particularly defined otherwise, an alkoxy group having 1 to 20, 1 to 16, 1 to 12, 1 to 8, or 1 to 4 carbon atoms. The alkoxy group may be linear, branched, or cyclic, and subject to substitution with at least one substituent.

The term "monovalent hydrocarbon group" may refer to a monovalent residue derived from a compound consisting of carbon and hydrogen or a compound in which at least one hydrogen in the compound consisting of carbon and hydrogen is subject to substitution with an arbitrary substituent. The monovalent hydrocarbon group may include, for example, 1 to 20, 1 to 16, 1 to 12, 1 to 8, or 1 to 4 carbon atoms. As the monovalent hydrocarbon group, an alkyl group, an alkenyl group, an alkynyl group, or an aryl group may be used.

The term "alkyl group" used herein may refer to, unless specifically defined otherwise, an alkyl group having 1 carbon atom to 20 carbon atoms, 1 carbon atom to 16 carbon atoms, 1 carbon atom to 12 carbon atoms, 1 carbon atom to 8 carbon atoms, or 1 carbon atom to 4 carbon atoms. The alkyl group may have a linear, branched, or cyclic structure, and may be optionally substituted with at least one substituent.

The term "alkenyl group" used herein may refer to, unless specifically defined otherwise, an alkenyl group having 2 carbon atoms to 20 carbon atoms, 2 carbon atoms to 16 carbon atoms, 2 carbon atoms to 12 carbon atoms, 2 carbon atoms to 8 carbon atoms, or 2 carbon atoms to 4 carbon atoms. The alkenyl group may have a linear, branched, or cyclic structure, and may be optionally substituted with at least one substituent.

The term "alkynyl group" used herein may refer to, unless specifically defined otherwise, an alkynyl group having 2 carbon atoms to 20 carbon atoms, 2 carbon atoms to 16 carbon atoms, 2 carbon atoms to 12 carbon atoms, 2 carbon atoms to 8 carbon atoms, or 2 carbon atoms to 4 carbon atoms. The alkynyl group may have a linear, branched, or cyclic structure, and may be optionally substituted with at least one substituent.

In the specification, a halogen, a hydroxyl group, an epoxy group, an acryl group, a methacryl group, an acryloyl group, a methacryloyl group, an isocyanate group, a thiol group, or a monovalent hydrocarbon group may be used as a substituent that can be optionally substituted to an epoxy group, an acryloyl group, a methacryloyl group, an alkoxy group, or a monovalent hydrocarbon group.

In Formula 1, R¹ and R² may be, for example, each independently an alkyl group or an aryl group. The unit of Formula 1 is a D unit including at least one aryl group binding to a silicon atom. The aryl group may be, for example, a phenyl group. When an alkyl group is included in the unit of Formula 1, the alkyl group may be, for example, a methyl group.

The unit of Formula 1 may be, for example, a unit of Formula 3 or 4.

[Formula 3] [(C₆H₅)(CH₃)SiO_{2/2}]

[Formula 4] [(C₆H₅)₂SiO_{2/2}]

When the silicon resin includes the unit of Formula 1, in one embodiment, a molar ratio (Ar/Si) of aryl (Ar) groups included in Formula 1 with respect to all silicon (Si) atoms included in the silicon resin, or a ratio of the sum ((Ar+Ak)/Si) of a mole of aryl (Ar) groups and a mole of alkyl (Ak) groups included in the unit of Formula 1 with respect to a mole of all silicon (Si) atoms included in the silicon resin may be 0.5 to 0.9 or 0.7 to 0.85. Within the above range, physical properties of the resin layer may be improved.

Formula 2 is a T unit including an aryl group binding to a silicon atom. In one embodiment, the unit of Formula 2 may be a unit represented by Formula 5.

[Formula 5] (C₆H₅)SiO_{3/2}

When the silicon resin includes the unit of Formula 2, for example, a molar ratio (Ar/Si) of aryl (Ar) groups included in the unit of Formula 2 with respect to all silicon (Si) atoms included in the silicon resin may be 0.5 to 0.9 or 0.7 to 0.85. Within the above range, physical properties of the resin layer may be improved.

In one embodiment, all aryl groups included in the silicon resin may be included in the unit(s) of Formla(s) 1 and 2. In this case, the unit of Formula 1 is a unit of Formula 3 or 4, and the unit of Formula 2 may be a unit of Formula 5.

The silicon resin may be represented by, for example, an average compositional formula of Formula 6.

[Formula 6] (R₃SiO)_{1/2})ₐ(R₂SiO_{2/2})_{b}(RSiO_{3/2})_{c}(SiO_{4/2})_{d}

In Formula 6, Rs are a substituent binding to a silicon atom, and each independently hydrogen, a hydroxyl group, an epoxy group, an acryloyl group, a methacryloyl group, an isocyanate group, an alkoxy group, or a monovalent hydrocarbon group. At least one of Rs is an aryl group, and when a+b+c+d is converted into 1, a is 0 to 0.6, b is 0 to 0.97, c is 0 to 0.8, d is 0 to 0.4, and b and c are not simultaneously 0.

In the specification, the expression "the silicon resin is represented as a specific average compositional formula" means that a single silicon resin included in a resin layer is represented as the average compositional formula, and various resin components are present in a resin layer, and when an average of the composition of the various resin components is obtained, the average of the composition is also represented as the average compositional formula.

In Formula 6, Rs are substituents directly binding to a silicon atom, are identical to or different from each other, and are each independently hydrogen, a hydroxyl group, an epoxy group, an acryloyl group, a methacryloyl group, an isocyanate group, an alkoxy group, or a monovalent hydrocarbon group.

In Formula 6, at least one of Rs may be an aryl group, for example, a phenyl group. The aryl group may be included in a silicon resin to satisfy the above-described molar ratio (Ar/Si).

In Formula 6, at least one of Rs may also be hydrogen, a hydroxyl group, an epoxy group, an acryloyl group, a methacryloyl group, an isocyanate group, an alkoxy group, or an alkenyl group. When such a functional group is included, physical properties of the resin layer, for example, adhesiveness, may further be improved.

In Formula 6, a, b, c, and d are each independently a mole fraction of a siloxane unit, and when the sum thereof is converted into 1, a may be 0 to 0.6 or 0 to 0.5, b may be 0 to 0.97 or 0 to 0.8, c may be 0 to 0.8 or 0 to 0.7, and d may be 0 to 0.4 or 0 to 0.2. Here, b and c are not simultaneously 0. That is, the silicon resin of Formula 6 may include a T or Q unit.

The silicon resin may have a molecular weight of approximately 500 to 200,000 or 1,000 to 200,000. When the resin having the above range of molecular weight is used, the resin layer may have excellent physical properties such as hardness, and also have improved workability in the formation of the resin layer. Unless specifically defined otherwise, the term "molecular weight of the silicon resin" means a weight average molecular weight (Mw) of the silicon resin. The weight average molecular weight may be, for example, a conversion value with respect to standard polystyrene measured by gel permeation chromatography (GPC).

The resin layer further includes a light resistance providing agent. The light resistance providing agent may prevent damage to the sheet, and enhance overall durability of the resin layer even when the sheet is exposed to short wavelength UV rays. As the light resistance providing agent, for example, a UV absorbent and/or a photostabilizer may be used.

As the UV absorbent, for example, at least one selected from a benzophenone compound, a benzotriazol compound, and a triazine compound may be used, but the present application is not limited thereto. As the benzophenone compound, 2,4-dihydroxybenzophenone, 2-hydroxy-4-methoxy benzophenone, 2-hydroxy-4-methoxy benzophenone-5-sulfonic acid, 2-hydroxy-4-n-octyloxy benzophenone, 2-hydroxy-4-n-dodecyloxybenzophenone, 2-hydroxy-4-benzyloxy benzophenone, bis(5-benzoyl-4-hydroxy-2-methoxyphenyl)methane, 2,2'-dihydroxy-4-methoxy benzophenone, or 2,2'-dihydroxy-4,4'-dimethoxy benzophenone may be used, as the benzotriazole compound, 2-(2'-hydroxy-5'-methylphenyl)benzotriazole, 2-(2'-hydroxy-5'-tert-butylphenyl)benzotriazole, 2-(2'-hydroxy-3',5'-di-tert-butylphenyl)benzotriazole, 2-(2'-hydroxy-5'-tent-octylphenyl)benzotriazole, or 2-(2'-hydroxy-3',5'-di-tert-octylphenyl)benzotriazole, TINUBIN 1130, TINUBIN 384, TINUBIN 571, or TINUBIN 900 produced by Nippon Ciba Geigy may be used, and as the triazine compound, for example, TINUBIN 400, TINUBIN 405, TINUBIN 460, TINUBIN 477DW, or TINUBIN 479 produced by Nippon Ciba Geigy may be used.

As the photostabilizer, for example, a hindered amine compound may be used. The hindered amine compound may be, but is not limited to, bis(2,2,6,6-tetramethyl-4-piperidyl)succinate, bis(2,2,6,6-tetramethyl-4-piperidyl) sebacate, or bis(1,2,2,6,6-pentamethyl-4-piperidyl)-2-(3,5-di-tert-butyl-4-hydroxybenzyl)-2-butyl malonate, or TINUBIN 292 or TINUBIN 123 produced by Nippon Ciba Geigy, or ADK STAB LA82 or ADK STAB LA87 produced by ADEKA.

The resin layer may include the light resistance providing agent at 0.05 to 10 or 0.1 to 10 parts by weight with respect to 100 parts by weight of the silicon resin. When the content of the light resistance providing agent is maintained at 0.05 to 10 parts by weight, the durability of the resin layer may be excellently maintained. Unless specifically defined otherwise, the units "parts by weight" means a weight ratio between components.

In one embodiment, when the resin layer simultaneously includes a UV absorbent and a photostabilizer as the light resistance providing agents, the light resistance providing agent may include 10 to 70, 20 to 60, or 30 to 40 parts by weight of the photostabilizer with respect to 100 parts by weight of the UV absorbent within the above range of the ratio. As described above, when the UV absorbent and the photostabilizer are simultaneously included, the durability of the resin layer may be further enhanced.

The resin layer may further include light scattering or light reflective particles. The light scattering or light reflective particles are particles that can scatter or reflect incident light onto the resin layer, and as long as such a function is exhibited, various kinds of particles may be used. For example, as the light scattering particles, particles having a different refractive index from the resin layer may be used. The particles may have a refractive index of 1.5 or more with respect to, for example, light having a wavelength of 450 nm. The upper limit of the refractive index of the particles is not particularly limited, and may be set in consideration of a necessary scattering ability. The light scattering or light reflective particles may further improve light efficiency or a UV blocking effect of the resin layer. As the light scattering or light reflective particles, for example, glass such as glass beads, or inorganic particles such as alumina, titania, zirconia, cerium oxide, hafnium oxide, niobium pentoxide, tantalum pentoxide, indium oxide, tin oxide, indium tin oxide, zinc oxide, silicon-based particles, zinc sulfate, barium sulfate, calcium carbonate, titanium oxide, or magnesium oxide may be used.

The light scattering or light reflective particles may have an average particle diameter of, for example, 40 nm to 100,000 nm, 40 nm to 50,000 nm, or 200 nm to 10,000 nm. Within such a range of the average particle diameter, the particles may be uniformly dispersed in the resin layer, and excellently maintain processability or adhesiveness.

The light scattering or light reflective particles may be included in the resin layer at 0.1 to 50 or 0.1 to 30 parts by weight with respect to 100 parts by weight of the silicon resin. Within such a range of the weight ratio, light scattering ability, reflectivity, processability, and adhesiveness of the resin layer may be excellently maintained.

The resin layer may further include a known additive, when needed. As the additive, various kinds of thermoplastic resins, flame-retardants, UV stabilizers, glass fiber, glass beads, or optical brightening agents may be used, but the present application is not limited thereto.

Another aspect of the present application provides a method of manufacturing a sheet for a photovoltaic cell including forming a resin layer using a liquid-type coating solution including a silicon resin or a precursor thereof; and a light resistance providing agent. As a silicon resin included in the liquid-type coating solution, the silicon resin described above may be used. In addition, the precursor may include, for example, at least one component that can form the silicon resin through curing. The resin layer may be formed by, for example, coating the liquid-type coating solution, and curing or drying the coated material.

In one embodiment, the sheet for a photovoltaic cell may be manufactured by coating a liquid-type coating solution including the silicon resin or a precursor which can form the resin through a curing process, or like. along with the light resistance providing agent on the base layer, and forming a resin layer.

The kind of the precursor that can form a silicon resin, for example, a liquid silicon-based material, is not particularly limited, and various components known in the art may be employed without limitation. For example, the component may be an addition-curable silicon-based material, a condensation-curable or polycondensation-curable silicon-based material, a UV-curable silicon-based material, or a peroxide-vulcanized silicon-based material.

The addition-curable silicon-based material is a material cured through hydrosilylation. The material at least includes an organic silicon compound having a hydrogen atom directly binding to a silicon atom and an organic silicon compound having an aliphatic unsaturated group such as a vinyl group, and the compound is cured by reaction with a catalyst. An example of the catalyst may include a group 8 metal on the periodic table, or a catalyst carrying the metal in a carrier such as alumina, silica, or carbon black, or a salt or complex of the metal. As the group 8 metal on the periodic table, for example, platinum, rhodium, or ruthenium may be used.

A method using a condensation or polycondensation-curable silicon-based material is a method of preparing a silicon resin through hydrolysis and condensation of a silicon compound such as a silane or siloxane having a hydrolysable functional group such as -Cl, -OCH₃, -OC(O)CH₃, -N(CH₃)₂,-NHCOCH₃, or -SCH₃, or a hydrolysate thereof. As a unit compound that can be used in this method, a silane compound such as R^{a}₃Si(OR^{b}), R^{a}₂Si(OR^{b})₂, R^{a}Si(OR^{b})₃, and Si(OR^{b})₄ may be used. Here, (OR^{b}) may be a linear or branched alkoxy group having 1 to 8 carbon atoms, for example, methoxy, ethoxy, n-propoxy, n-butoxy, isopropoxy, isobutoxy, sec-butoxy, or t-butoxy. In addition, in the compound, R^{a} is a functional group binding to a silicon atom, which is selected in consideration of a substituent included in a desired silicon resin.

According to a method using a UV-curable silicon-based material, a desired resin is prepared by preparing a resin through hydrolysis and condensation of a silicon compound such as a silane or siloxane having a UV reactor such as an acryloyl group, or a hydrolysate thereof, and performing UV radiation.

Various materials are known, and in consideration of a desired silicon resin, a liquid-type coating solution may be prepared by suitably employing a known material by one of ordinary skill in the art.

A method of coating a liquid-type coating solution is not particularly limited, and for example, a known method such as bar coating, spin coating, or comma coating may be used. For example, a coating layer formed by this method may be cured and/or dried under suitable conditions, thereby forming a resin layer.

A method of forming the resin layer is not particularly limited. For example, a method of extruding and curing a material to a process base layer, or a method of preparing a sheet or film-type product using the material, and laminating the product on a base layer may be used.

Another aspect of the present application provides a photovoltaic module. The illustrative photovoltaic module may include the sheet for a photovoltaic cell described above, a substrate, and an element, for example, a photoelectric transducer. The element may be encapsulated by an encapsulant between the sheet for a photovoltaic cell and the substrate.

In the photovoltaic module, the sheet for a photovoltaic cell may be applied as, for example, a back sheet or a support substrate. The photovoltaic module may be formed in various shapes as long as it includes the sheet for a photovoltaic cell, and the shape includes a silicon wafer-based photovoltaic module or a thin film-type photovoltaic module.

FIGS. 3 and 4 are schematic diagrams of an illustrative photovoltaic module. FIG. 3 schematically shows an embodiment of a module(300) including a sheet for a photovoltaic cell(301), which is a module(300) including a silicon-based photovoltaic wafer as a photoelectric transducer(303). As shown in FIG. 3, an illustrative module(300) may include a top substrate(302) conventionally formed of a ferroelectric material such as glass, a back sheet(301), a photoelectric transducer(303) such as a silicon-based wafer, and an encapsulant(304) encapsulating the element(303). As the encapsulant, for example, an EVA-based or silicon-based material may be used. When a silicon-based material is used as the encapsulant, compatibility with the sheet for a photovoltaic cell used as the back sheet(301) may be enhanced, but the present application is not limited thereto.

FIG. 4 is a schematic diagram of a thin film-type photovoltaic module as another illustrative module(400). As shown in FIG. 4, in the thin film-type photovoltaic module(400), the photoelectric transducer(402) may be conventionally formed on a top substrate(401), which is a ferroelectric. The element(402) may be encapsulated by an encapsulant(403) between the top substrate(401) and the sheet for a photovoltaic cell that is a supporting substrate(301). The photoelectric transducer(402) that is a conventional thin film may be formed by, for example, chemical vapor deposition (CVD).

For example, other components or a manufacturing method is not particularly limited, and a common method used in the art may be applied without particular limitation, as long as the sheet for a photovoltaic cell is included in a photovoltaic module as a support member.

### EFFECT

According to the present application, a sheet for a photovoltaic cell having excellent moisture barrier property, weather resistance, moisture resistance, thermal resistance, and light resistance and a photovoltaic module including the same can be provided.

### DESCRIPTION OF DRAWINGS

FIGS. 1 and 2 are diagrams of a sheet for a photovoltaic cell; and
FIGS. 3 and 4 are diagrams of a photovoltaic module.

### ILLUSTRATIVE EMBODIMENTS

Hereinafter, a sheet for a photovoltaic cell will be described in detail with reference to Examples and Comparative Examples, but the range of the sheet is not limited to the following Examples (in Examples and Comparative Examples, Vi is a vinyl group, Me is a methyl group, Ph is a phenyl group, and Ep is an epoxy group).

### Example 1

### Preparation of silicon resin precursor (A)

As a siloxane compound synthesized by a conventional method, a curable composition, a precursor (A), was prepared by mixing a compound represented by one of Formulas A to D, blending a catalyst and 5 g of a UV absorbent (TINUBIN 384, Nippon Ciba Geigy), and curing the mixture by hydrosilylation (blending amounts: compound of Formula A: 100 g, compound of Formula B: 10 g, compound of Formula C: 200 g, compound of Formula D: 60 g). As a catalyst, a platinum catalyst (Platinum(0)-1,3-divinyl-1,1,3,3-tetramethyldisiloxane) was blended in an amount in which a content of Pt(0) becomes 20 ppm.

[Formula A] (ViMe₂SiO_{1/2})₂(Ph₂SiO_{2/2})₁₀(Me₂SiO_{2/2})₁₀

[Formula B] (ViMe₂SiO_{1/2})₂(EpSiO_{3/2})₃(MePhSiO_{2/2})₁₅

[Formula C] (ViMe₂SiO_{1/2})₃(MePhSiO_{2/2})(PhSiO_{3/2})₉

[Formula D] (HMe₂SiO_{1/2})₂(Ph₂SiO_{2/2})_{1.5}

### Preparation of resin layer (A)

A sheet-shape resin layer having a thickness of 1 mm was formed by coating the prepared precursor (A) and curing the coated precursor (A) at approximately 150°C for approximately 1 hour.

### Comparative Example 1

A resin layer (B) was formed by the same method as described in Example 1, except that a precursor (B) as a curable composition (blended amount: compound of Formula E: 100 g, compound of Formula F: 20 g, compound of Formula G: 50g) prepared by mixing compositions of Formulas E to G synthesized by a known method, and additionally blending a catalyst and 10 g of a UV absorbent (TINUBIN 384, Nippon Ciba Geigy). As the catalyst, a platinum catalyst (platinum(0)-1,3-divinyl-1,1,3,3-tetramethyldisiloxane) was blended with the precursor (B) to have a Pt(0) content of 10 ppm.

[Formula E] (ViMe₂SiO_{1/2})₂(ViMeSiO_{2/2})₁₅(MeSiO_{3/2})₅(Me₂SiO_{2/2})₅₀

[Formula F] (ViMe₂SiO_{1/2})₂(Me₂SiO_{3/2})₆(PhSiO_{3/2})_{1.5}

[Formula G] (HMe₂SiO_{1/2})₂(HMeSiO_{2/2})₂(Me₂SiO_{2/2})₁₀

### Comparative Example 2

A resin layer (C) was formed by the same method as described in Example 1, except that a precursor (C) as a curable composition (blended amount: compound of Formula H: 100 g, compound of Formula I: 20 g, compound of Formula J: 50g) prepared by mixing compositions of Formulas H to J synthesized by a known method, and additionally blending a catalyst and 10 g of a UV absorbent (TINUBIN 384, Nippon Ciba Geigy). As the catalyst, a platinum catalyst (platinum(0)-1,3-divinyl-1,1,3,3-tetramethyldisiloxane) was blended with the precursor (C) to have a Pt(0) content of 20 ppm.

[Formula H] (ViPh₂SiO_{1/2})₂(Me₂SiO_{2/2})₂₀

[Formula I] (ViPh₂SiO_{1/2})₃(MeSiO_{3/2})₁₀

[Formula J] (HMe₂SiO_{1/2})₂(HMeSiO_{2/2})₂(Me₂SiO_{2/2})₁₀

### Experimental Example 1. Measurement of moisture

### transmittance

A moisture transmittance was measured using a Mocon apparatus under the same conditions in a thickness direction with respect to the resin layer formed in Example 1 or Comparative Example 1 or 2, and results are shown in Table 1.

**[Table 1]**

| | Example 1 | Comparative Example 1 | Comparative Example 2 |
|---|---|---|---|
| Moisture transmittance | 15 g/cm² day | 101 g/cm² day | 120 g/cm² day |

### Example 2

### Preparation of precursor (D)

As a siloxane compound synthesized by a known method, compounds represented by Formulas K to N were mixed (blended amount: compound of Formula K: 100 g, compound of Formula L: 3 g, compound of Formula M: 50 g, compound of Formula N: 20 g). 0.001 g of a platinum catalyst (Platinum(0)-1,3-divinyl-1,1,3,3-tetramethyldisiloxane), 10 g of a UV absorbent (TINUBIN 384, Nippon Ciba Geigy), and 4 g of a photostabilizer (TINUBIN 123, Nippon Ciba Geigy) were blended with the mixture, thereby preparing a curable composition, which is a precursor (D).

[Formula K] (ViMe₂SiO_{1/2})₂(ViMeSiO_{2/2})₅(Ph₂SiO_{2/2})₂₀(Me₂SiO_{2/2})₄₀

[Formula L] (ViMe₂SiO_{1/2})₂(MeEpSiO_{2/2})₅(Ph₂SiO_{2/2})₁₀(Me₂SiO_{2/2})₁₀

[Formula M] (ViMe₂SiO_{1/2})_{2.5}(PhSiO_{3/2})₅

[Formulas N] (HMe₂SiO_{½})₂(Ph₂SiO_{2/2}))_{1.5}

### Preparation of sheet for photovoltaic cell

Resin layers were formed on both surfaces of a poly(ethylene terephthalate) (PET) sheet by repeatedly performing coating and curing the precursor (D) on the PET sheet. Here, the curing of the coating layer was performed at 150°C for 1 hour.

### Example 3

A sheet for a photovoltaic cell was manufactured by the same method as described in Example 2, except that a precursor (E) prepared by additionally blending 10 g of titanium dioxide (TiO2, average diameter: 3 µm) into the precursor prepared in Example 2.

### Example 4

A precursor was prepared by the same method as described in Example 2, and a sheet for a photovoltaic cell was prepared, except that a photostabilizer was omitted.

### Comparative Example 3

A precursor and a sheet for a photovoltaic cell were prepared as described in Example 1, except that a UV absorbent (TINUBIN 384, Nippon Ciba Geigy) and a photostabilizer (TINUBIN 123, Nippon Ciba Geigy) were blended in preparation of a curable composition.

Reliability and yellowing resistance were measured at a high temperature and high humidity with respect to Examples 2 and 3 and Comparative Example 3, and results are summarized in Table 2.

### 1. Measurement of reliability at high temperature and high humidity

A PET sheet on which the resin layer formed in Example or Comparative Example was left at 85°C and relative humidity of 85% for 1,000 hours, and occurrence of peeling between the resin layer and the PET was observed and evaluated under the following criteria.

### <Evaluation Criteria>

O: No peeling occurs between resin layer and PET sheet.
X: Peeling occurs between resin layer and PET sheet.

### 2. Measurement of degree of yellowing

Radiation of light was performed on a resin layer formed in Example or Comparative Example to have a thickness of 1 mm using Q-UVA (340 nm, 0.89 W/ Cm²) at 60°C for 3 days, and yellowing was observed and evaluated under the following criteria.

### <Evaluation criteria>

O: absorption rate of light at a wavelength of 450 nm of less than 5%
X: absorption rate of light at a wavelength of 450 nm of 5% or more

**[Table 2]**

| | Example 2 | Example 3 | Example 4 | Comparative Example 3 |
|---|---|---|---|---|
| Durability and reliability | O | O | O | X |
| Yellowing | O | O | O | X |

### <Descriptions of reference numerals>

100, 200, 301: sheet for photovoltaic cell
101, 201: base layer
102, 202, 203: resin layer
300, 400: photovoltaic module
302, 401: top substrate
304, 403: encapsulant
303, 402: photoelectric transducer

## Claims

1. A sheet for a photovoltaic cell, comprising: a resin layer that comprises a silicon resin which comprises an aryl group, of which a molar ratio of the aryl group with respect to silicon atoms comprised therein is more than 0,3, and which comprises a siloxane unit of Formula 1 and a siloxane unit of Formula 2; and a light resistance providing agent:
[Formula 1] (R¹R²SiO_{2/2})
[Formula 2] (R³SiO_{3/2})
wherein R¹ and R² are each independently hydrogen, a hydroxyl group, an epoxy group, an acryloyl group, a methacryloyl group, an isocyanate group, an alkoxy group, or a monovalent hydrocarbon group, at least one of the R¹ and R² is an aryl group, and R³ is an aryl group.

2. The sheet according to claim 1, further comprising a base layer, on one surface of which the resin layer is formed, and a second resin layer which is formed on the other surface of the base layer and which comprises a silicon resin that comprises an aryl group and has a molar ratio of the aryl group with respect to silicon atoms comprised therein of more than 0.3.

3. he sheet according to claim 1 or 2, wherein a molar ratio of the aryl group with respect to total silicon atoms comprised in the silicon resin is 0.5 or more.

4. The sheet according to any one of claims 1-3, wherein the silicon resin has an average compositional formula of Formula 6:
[Formula 6] (R₃SiO_{1/2})ₐ(R₂SiO_{2/2})_{b}(RSiO_{3/2})_{c}(SiO_{4/2})_{d}
wherein R's are a substituent directly binding to a silicon atom, which are each independently hydrogen, a hydroxyl group, an epoxy group, an acryloyl group, a methacryloyl group, an isocyanate group, an alkoxy group, or a monovalent hydrocarbon group, at least one of R's is an aryl group, and, in a case where a+b+c+d is converted into 1, a is 0 to 0.6, b is 0 to 0.97, c is 0 to 0.8, d is 0 to 0.4; and b and c are not simultaneously 0.

5. The sheet according to any one of claims 1 to 4, wherein the silicon resin has a weight average molecular weight of 500 to 100,000.

6. The sheet according to any one of claims 1 to 5, wherein the light resistance providing agent is at least one selected from the group consisting of a UV absorbent and a photostabilizer.

7. The sheet according to claim 6, wherein the UV stabilizer is a benzophenone compound, a benzotriazole compound, or a triazine compound.

8. The sheet according to claim 6, wherein the photostabilizer is a hindered amine compound.

9. The sheet according to any one of claims 1 to 5, wherein the light resistance providing agent comprises a UV absorbent and a photostabilizer.

10. The sheet according to claim 1, wherein the resin layer comprises a light resistance providing agent at 0.05 parts by weight to 10 parts by weight with respect to 100 parts by weight of the silicon resin.

11. The sheet according to claim 13, wherein the light resistance providing agent comprises the photostabilizer at 10 parts by weight to 70 parts by weight with respect to 100 parts by weight of the UV absorbent.

12. The sheet according to claim 1, wherein the resin layer further comprises photoscattering or photoreflective particles.

13. The sheet according to claim 12, wherein the photoscattering or photoreflective particles are formed of at least one selected from the group consisting of glass, alumina, titania, zirconia, cerium oxide, hafnium oxide, niobium pentoxide, tantalum pentoxide, indium oxide, tin oxide, indium tin oxide, zinc oxide, silicon-based particles, zinc sulfate, barium sulfate, calcium carbonate, titanium oxide, and magnesium oxide.

14. A method of manufacturing a sheet for a photovoltaic cell, comprising:
forming a resin layer using a liquid coating solution comprising a silicon resin which comprises an aryl group, of which a molar ratio of the aryl group with respect to silicon atoms comprised therein is more than 0.3, and which comprises a siloxane unit of Formula 1 and a siloxane unit of Formula 2, or a precursor thereof:
[Formula 1] (R¹R²SiO_{2/2})
[Formula 2] (R³SiO_{3/2})
wherein R¹ and R² are each independently hydrogen, a hydroxyl group, an epoxy group, an acryloyl group, a methacryloyl group, an isocyanate group, an alkoxy group, or a monovalent hydrocarbon group, at least one of the R¹ and R² is an aryl group, and R³ is an aryl group.

15. A photovoltaic module, comprising: the sheet for a photovoltaic cell of any one of claims 1 to 13;a substrate; and an encapsulant encapsulating an element between the sheet for a photovoltaic cell and the substrate.

## Patentansprüche

1. Folie für eine Photovoltaikzelle, umfassend: eine Harzschicht, die ein Silikonharz umfasst, das eine Arylgruppe umfasst, wobei ein Molverhältnis der Arylgruppe in Bezug auf Siliziumatome, die darin umfasst sind, mehr als 0,3 ist, und welches eine Siloxaneinheit der Formel 1 und eine Siloxaneinheit der Formel 2 umfasst; und ein Lichtbeständigkeit bereitstellendes Agens:
[Formel 1] (R¹R²SiO_{2/2})
[Formel 2] (R³SiO_{3/2}),
wobei R¹ und R² jeweils unabhängig Wasserstoff, eine Hydroxylgruppe, eine Epoxygruppe, eine Acryloylgruppe, eine Methacryloylgruppe, eine Isocyanatgruppe, eine Alkoxygruppe oder eine einwertige Kohlenwasserstoffgruppe sind, wobei wenigstens eines der R¹ und R² eine Arylgruppe ist, und R³ eine Arylgruppe ist.

2. Folie nach Anspruch 1, weiter umfassend eine Basisschicht, wobei auf einer Oberfläche derselben die Harzschicht gebildet ist, und eine zweite Harzschicht, die auf der anderen Seite der Basisschicht gebildet ist und die ein Silikonharz umfasst, das eine Arylgruppe umfasst und das ein Molverhältnis der Arylgruppe in Bezug auf Siliziumatome, die darin umfasst sind, von mehr als 0,3 aufweist.

3. Folie nach Anspruch 1 oder 2, wobei ein Molverhältnis der Arylgruppe in Bezug auf gesamte Siliziumatome, die in dem Silikonharz umfasst sind, 0,5 oder mehr ist.

4. Folie nach einem der Ansprüche 1 bis 3, wobei das Silikonharz eine durchschnittliche Zusammensetzungsformel der Formel 6 aufweist:
[Formel 6] (R₃SiO_{1/2})ₐ(R₂SiO_{2/2})_{b}(RSiO_{3/2})_{c}(SiO_{4/2})_{d},
wobei Rs ein Substituent sind, der direkt an ein Siliziumatom angebunden ist, welche jeweils unabhängig Wasserstoff, eine Hydroxylgruppe, eine Epoxygruppe, eine Acryloylgruppe, eine Methacryloylgruppe, eine Isocyanatgruppe, eine Alkoxygruppe oder eine einwertige Kohlenwasserstoffgruppe sind, wobei wenigstens eines der Rs eine Arylgruppe ist, und im Falle, wo a+b+c+d gleich 1 gesetzt ist, a 0 bis 0,6 ist, b 0 bis 0,97 ist, c 0 bis 0,8 ist, d 0 bis 0,4 ist; und b und c nicht gleichzeitig 0 sind.

5. Folie nach einem der Ansprüche 1 bis 4, wobei das Silikonharz ein Gewichtsmittelmolekulargewicht von 500 bis 100.000 aufweist.

6. Folie nach einem der Ansprüche 1 bis 5, wobei das Lichtbeständigkeit bereitstellende Agens wenigstens eines ausgewählt aus der Gruppe bestehend aus einem UV-Absorptionsmittel und einem Photostabilisator ist.

7. Folie nach Anspruch 6, wobei der UV-Stabilisator eine Benzophenonverbindung, eine Benzotriazolverbindung oder eine Triazinverbindung ist.

8. Folie nach Anspruch 6, wobei der Photostabilisator eine gehinderte Aminverbindung ist.

9. Folie nach einem der Ansprüche 1 bis 5, wobei das Lichtbeständigkeit bereitstellende Agens ein UV-Absorptionsmittel und einen Photostabilisator umfasst.

10. Folie nach Anspruch 1, wobei die Harzschicht ein Lichtbeständigkeit bereitstellendes Agens mit 0,05 Gewichtsteilen bis 10 Gewichtsteilen in Bezug auf 100 Gewichtsteile des Silikonharzes umfasst.

11. Folie nach Anspruch 9, wobei das Lichtbeständigkeit bereitstellende Mittel den Photostabilisator mit 10 Gewichtsteilen bis 70 Gewichtsteilen in Bezug auf 100 Gewichtsteile des UV-Absorptionsmittels umfasst.

12. Folie nach Anspruch 1, wobei die Harzschicht ferner photostreuende oder photoreflektive Teilchen umfasst.

13. Folie nach Anspruch 12, wobei die photostreuenden oder photoreflektiven Teilchen aus wenigstens einem gebildet sind ausgewählt aus der Gruppe bestehend aus Glas, Aluminiumoxid, Titanoxid, Zirkoniumoxid, Ceroxid, Hafniumoxid, Niobpentoxid, Tantalpentoxid, Indiumoxid, Zinnoxid, Indium-Zinn-Oxid, Zinkoxid, Teilchen auf Siliciumbasis, Zinksulfat, Bariumsulfat, Calciumcarbonat, Titanoxid und Magnesiumoxid.

14. Verfahren zum Herstellen einer Folie für eine Photovoltaikzelle, umfassend:
Bilden einer Harzschicht unter Verwendung einer flüssigen Beschichtungslösung umfassend ein Silikonharz, das eine Arylgruppe umfasst, wobei ein Molverhältnis der Arylgruppe in Bezug auf Siliziumatome, die darin umfasst sind, mehr als 0,3 ist, und welches eine Siloxaneinheit der Formel 1 und eine Siloxaneinheit der Formel 2 oder eine Vorstufe derselben umfasst:
[Formel 1] (R¹R²SiO_{2/2})
[Formel 2] (R³SiO_{3/2}),
wobei R¹ und R² jeweils unabhängig Wasserstoff, eine Hydroxylgruppe, eine Epoxygruppe, eine Acryloylgruppe, eine Methacryloylgruppe, eine Isocyanatgruppe, eine Alkoxygruppe oder eine einwertige Kohlenwasserstoffgruppe sind, wobei wenigstens eines der R¹ und R² eine Arylgruppe ist, und R³ eine Arylgruppe ist.

15. Photovoltaikmodul, umfassend: die Folie für eine Photovoltaikzelle nach einem der Ansprüche 1 bis 13; ein Substrat; und ein Einkapselungsmittel einkapselnd ein Element zwischen der Folie für eine Photovoltaikzelle und dem Substrat.

## Revendications

1. Feuille pour une cellule photovoltaïque, comprenant une couche de résine qui comprend une résine silicium renfermant un groupe aryle, dont un rapport molaire du groupe aryle aux atomes de silicium qui y sont compris est supérieur à 0,3, et qui comprend une unité de siloxane de formule 1 et une unité de siloxane de formule 2 ; et un agent photorésistant :
[Formule 1] (R¹R²SiO_{2/2})
[Formule 2] (R³SiO_{3/2})
où R¹ et R² représentent chacun indépendamment l'hydrogène, un groupe hydroxyle, un groupe époxy, un groupe acryloyl, un groupe métacryloyl, un groupe isocyanate, un groupe alcoxy ou un groupe hydrocarbure monovalent, au moins l'un de R¹ et de R² représentant un groupe aryle et R³ représentant un groupe aryle.

2. Feuille selon la revendication 1, comprenant en outre une couche de base, sur une surface de laquelle la couche de résine est constituée, et une seconde couche de résine qui est constituée sur l'autre surface de la couche de base et qui comprend une résine de silicium renfermant un groupe aryle et ayant un rapport molaire du groupe aryle aux atomes de silicium qui y sont compris de plus de 0,3.

3. Feuille selon la revendication 1 ou la revendication 2, dans laquelle le rapport molaire du groupe aryle au total des atomes de silicium compris dans la résine de silicium est de 0,5 ou plus.

4. Feuille selon l'une quelconque des revendications 1 à 3, dans laquelle la résine de silicium présente une formule compositionnelle moyenne de formule 6 :
[Formule 6] (R₃SiO_{1/2})ₐ(R₂SiO_{2/2})_{b}(RSiO_{3/2})_{c}(SiO_{4/2})_{d}
où les R sont un substituant se liant directement à un atome de silicium, chacun représentant indépendamment l'hydrogène, un groupe hydroxyle, un groupe époxy, un groupe acryloyl, un groupe méthacryloyl, un groupe isocyanate, un groupe alcoxy ou un groupe hydrocarbure monovalent, au moins l'un des R représentant un groupe aryle, et, dans le cas où a + b + c + d est converti en 1, a vaut 0 à 0,6, b vaut 0 à 0,97, c vaut 0 à 0,8, d vaut 0 à 0,4 ; et b et c ne valent pas simultanément 0.

5. Feuille selon l'une quelconque des revendications 1 à 4, dans laquelle la résine de silicium a un poids moléculaire moyen en poids de 500 à 100 000.

6. Feuille selon l'une quelconque des revendications 1 à 5, dans laquelle l'agent photorésistant est au moins un agent sélectionné dans le groupe constitué d'un absorbeur de lumière ultraviolette (UV) et d'un photostabilisant.

7. Feuille selon la revendication 6, dans laquelle le photostabilisant de de lumière ultraviolette (UV) est un composé de benzophénone, un composé de benzotriazole ou un composé de triazine.

8. Feuille selon la revendication 6, dans laquelle le photostabilisant est un composé d'amine à encombrement stérique.

9. Feuille selon l'une quelconque des revendications 1 à 5, dans laquelle l'agent photorésistant comprend un absorbeur de lumière ultraviolette (UV) et un photostabilisant.

10. Feuille selon la revendication 1, dans laquelle la couche de résine comprend un agent photorésistant à raison de 0,05 parties en poids à 10 parties en poids par rapport à 100 parties en poids de la résine de silicium.

11. Feuille selon la revendication 13, dans lequel l'agent photorésistant comprend le photostabilisant à raison de 10 parties en poids à 70 parties en poids par rapport à 100 parties en poids de l'absorbeur de lumière ultraviolette.

12. Feuille selon la revendication 1, dans laquelle la couche de résine comprend en outre des particules de photo-diffusion ou photoréfléchissantes.

13. Feuille selon la revendication 12, dans laquelle les particules de photo-diffusion ou photoréfléchissantes sont constitués dudit au moins un élément sélectionné dans le groupe constitué de verre, d'alumine, de titane, de zircone, d'oxyde de cérium, d'oxyde de hafnium, de pentoxyde de niobium, de pentoxyde de tantale, d'oxyde d'indium, d'oxyde d'étain, d'oxyde d'indium et d'étain, d'oxyde de zinc, de particule à base de silicium, de sulfate de zinc, de sulfate de baryum, de carbonate de calcium, d'oxyde de titane et d'oxyde de magnésium.

14. Procédé de fabrication d'une feuille pour une cellule photovoltaïque, comprenant : la constitution d'une couche de résine en utilisant une solution de revêtement liquide qui comprend une résine de silicium renfermant un groupe aryle, un rapport molaire du groupe aryle aux atomes de silicium qui y sont compris étant de plus de 0,3, et qui comprend une unité de siloxane de formule 1 et une unité de siloxane de formule 2, ou un précurseur de celles-ci :
[Formule 1] (R¹R²SiO_{2/2})
[Formule 2] (R³SiO_{3/2})
où R¹ et R² représentent chacun indépendamment l'hydrogène, un groupe hydroxyle, un groupe époxy, un groupe acryloyl, un groupe métacryloyl, un groupe isocyanate, un groupe alcoxy ou un groupe hydrocarbure monovalent, au moins l'un de R¹ et de R² représentant un groupe aryle et R³ représentant un groupe aryle.

15. Module photovoltaïque, comprenant : la feuille pour une cellule photovoltaïque de l'une quelconque des revendications 1 à 13 ; un substrat ; et un encapsulant pour encapsuler un élément entre la feuille pour une cellule photovoltaïque et le substrat.
